Europäisches Patentamt

European Patent Office

Office européen des brevets

(19)

(11) Numéro de publication : **0 120 723**
**B1**

(12) # FASCICULE DE BREVET EUROPÉEN

(45) Date de publication du fascicule du brevet :
15.04.87

(21) Numéro de dépôt : 84400237.8

(22) Date de dépôt : 03.02.84

(51) Int. Cl.⁴ : **H 02 H   7/08, G 01 R 31/34**

(54) **Procédé et dispositif pour détecter si un moteur à courant continu est ralenti, et moteur comportant un tel dispositif.**

(30) Priorité : 18.03.83 FR 8304446

(43) Date de publication de la demande :
03.10.84 Bulletin 84/40

(45) Mention de la délivrance du brevet :
15.04.87 Bulletin 87/16

(84) Etats contractants désignés :
AT BE CH DE GB IT LI LU NL SE

(56) Documents cités :
FR-A- 2 269 232
PATENTS ABSTRACTS OF JAPAN, vol. 6, no. 173 (E-129)[1051], 1982, page 25 E 129
ELECTRONICS, vol. 40, no. 11, 29 mai 1967, pages 84-85; J.B. TIEDEMANN: "Permanent-magnet motor measures its own speed"

(73) Titulaire : **ETUDES TECHNIQUES ET REPRESENTA-TIONS INDUSTRIELLES E.T.R.I Société Anonyme
8 rue Boutard
F-92200 Neuilly-sur-Seine (FR)**

(72) Inventeur : **Guerin-Pinaud, Jacques
570 rue du Petit Clos Garel
F-27930 Evreux (FR)**

(74) Mandataire : **Bouju, André et al
Cabinet Bouju 38 avenue de la Grande Armée
F-75017 Paris (FR)**

Jouve, 18, rue St-Denis, 75001 Paris, France

## Description

La présente invention concerne un moteur à courant continu comprenant au moins deux enroulements, des moyens pour relier une première extrémité de chacun de ces enroulements à une première borne de tension continue, des moyens pour relier une seconde extrémité de chaque enroulement à une seconde borne de tension continue par l'intermédiaire d'un commutateur respectif, un élément mobile en rotation par rapport aux enroulements et présentant des pôles magnétiques disposés de façon à interagir avec les enroulements pour produire un couple moteur, des moyens pour commander les commutateurs de façon que sensiblement tout au long d'un tour complet de l'élément, et parmi un groupe comprenant au moins deux des enroulements précités, et pouvant comprendre la totalité des enroulements du moteur, il y ait un nombre constant d'enroulements qui soient alimentés et un nombre constant d'enroulements qui ne soient pas alimentés, et un dispositif de détection sensible à la vitesse du moteur. Un tel moteur est connu d'après le FR-A-2 269 232.

Selon ce document, un condensateur est monté pour interrompre, au bout d'un certain temps, l'alimentation d'un enroulement tendant à être alimenté de façon permanente lorsque le rotor est bloqué.

Ce dispositif a l'inconvénient de ne détecter que le blocage total, non le ralentissement, c'est-à-dire le passage de la vitesse au-dessous d'un seuil déterminé. En effet, ce n'est qu'en cas de blocage total que l'un des condensateurs se charge jusqu'à interrompre l'alimentation. Si le moteur tourne, même à faible vitesse, le dispositif de détection, globalement, n'intervient pas. Or même si le rotor du moteur est simplement freiné, mais non bloqué, par une anomalie quelconque, l'intensité traversant les enroulements augmente et met ceux-ci en danger.

Par ailleurs, il est connu de détecter la valeur de la force contre-électro-motrice aux bornes d'un moteur à courant continu et de la comparer à un seuil pour interrompre l'alimentation du moteur en cas de vitesse insuffisante (voir le résumé de JP-A-5 788 888 publié dans Patents Abstracts of Japan, vol. 6, n° 173 (1982), page 25E129).

Le but de l'invention est de remédier aux inconvénients du moteur décrit dans FR-A-2 269 232 en proposant un moteur à courant continu permettant de détecter les anomalies de vitesse de rotation, y compris les ralentissements excessifs.

Suivant l'invention, le moteur est caractérisé en ce que la seconde extrémité de chaque enroulement du groupe précité est en outre reliée à un point commun par l'intermédiaire d'une résistance respective, et en ce que le point commun est relié à l'entrée de moyens de comparaison pour comparer le potentiel présent au point commun avec un seuil de potentiel prédéterminé correspondant à un seuil de vitesse prédéterminé, de façon à détecter si la vitesse du moteur est inférieure audit seuil de vitesse.

L'invention procède de la constatation que dans un moteur du genre visé, la rotation des pôles magnétiques par rapport aux enroulements détermine dans ceux-ci une force électromotrice d'induction qu'il est possible de détecter par une mesure de tension pendant les intervalles de temps où l'enroulement n'est pas alimenté. La force électromotrice d'induction ainsi créée est fonction de la vitesse du rotor et elle disparaît quand le rotor est arrêté. ·

Ainsi, le point de jonction entre chaque enroulement du groupe d'enroulements et le commutateur associé est soumis à un potentiel qui est égal à celui de la deuxième borne de tension quand le commutateur est fermé, et qui est fonction de la vitesse du moteur lorsque le commutateur est ouvert. Tous lesdits points de jonction sont reliés à un point commun par l'intermédiaire d'une résistance. Le potentiel du point commun est donc l'addition pondérée des potentiels à chacun des points de jonction, dont ceux qui sont adjacents à un enroulement alimenté sont soumis au second potentiel d'alimentation et ceux qui sont adjacents à un enroulement non alimenté sont soumis à un potentiel fonction de la vitesse du moteur.

Le potentiel du point commun est donc fonction de la vitesse du moteur. Comme il y a un nombre constant d'enroulements alimentés et d'enroulements non alimentés, le potentiel du point commun est stable et constitue une mesure de la vitesse du moteur.

D'autres caractéristiques de l'invention ressortiront de la description donnée ci-après à titre illustratif et non limitatif, et du dessin annexé dans lequel :

la figure 1 est une vue axiale schématique montrant le rotor et le stator d'un moteur selon l'invention ;

la figure 2 est un schéma électrique du circuit de commutation d'un moteur selon l'invention ;

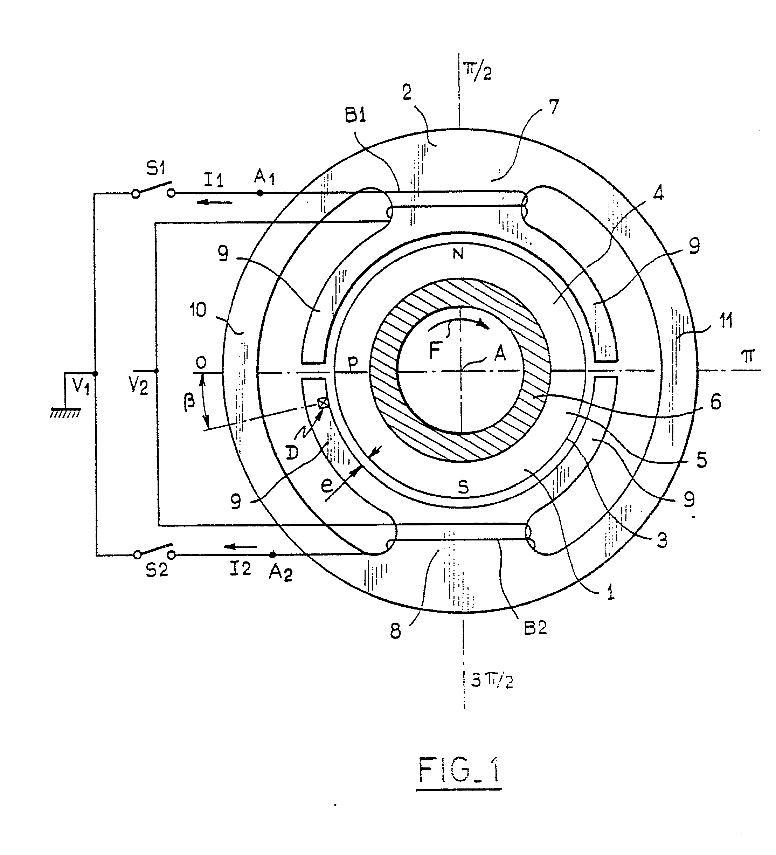

La figure 1 montre un exemple particulier d'un moteur où le rotor 1 d'axe A entraîne des aimants permanents 4, 5 et où le stator 2 porte les enroulements B1, B2 du type utilisé comme moteur de ventilateur de coffrets électriques.

Le rotor 1 possède une surface extérieure de révolution 3 formée par deux aimants permanents 4 et 5 collés sur un noyau tubulaire 6 et présentant respectivement des pôles nord et sud occupant chacun environ la moitié de la circonférence du rotor. L'autre pôle de chacun des aimants 4, 5 est dirigé vers l'axe A.

Le stator 2 comprend deux régions polaires 7 et 8 diamétralement opposées par rapport au rotor, élargies vers l'intérieur par des cornes polaires 9 de façon que chaque région polaire enveloppe presque la moitié du périmètre du rotor 1 avec un entrefer e constant, et réunies à l'extérieur par deux bras 10 et 11 fermant le circuit magnétique entre les régions polaires.

Les régions polaires 7 et 8 sont entourées respectivement par des enroulements $B_1$ et $B_2$ pouvant, dans la représentation schématique de la figure 1, être alimentés en courant respectivement par la fermeture de deux interrupteurs $S_1$ et $S_2$. Lorsque l'enroulement $B_1$ est alimenté, les régions 7 et 8 deviennent respectivement pôle sud et pôle nord, et le rotor tend à prendre la position montrée à la figure 1, l'aimant 4 faisant face à la région 7. Lorsque l'enroulement $B_2$ est alimenté, les régions 7 et 8 deviennent respectivement pôle nord et pôle sud, correspondant pour le rotor à une position d'équilibre symétrique de la précédente.

A l'extrémité avant du stator et face à la surface cylindrique formée par les aimants 4 et 5 du rotor, est placé un détecteur D de position du rotor. Le détecteur D est disposé au voisinage de l'extrémité de l'une des cornes de la région polaire 8, et est décalé d'un petit angle $\beta$ dans le sens trigonométrique par rapport au plan axial O, $\pi$ perpendiculaire à l'axe $\pi/2$, $3\pi/2$ des pôles du stator.

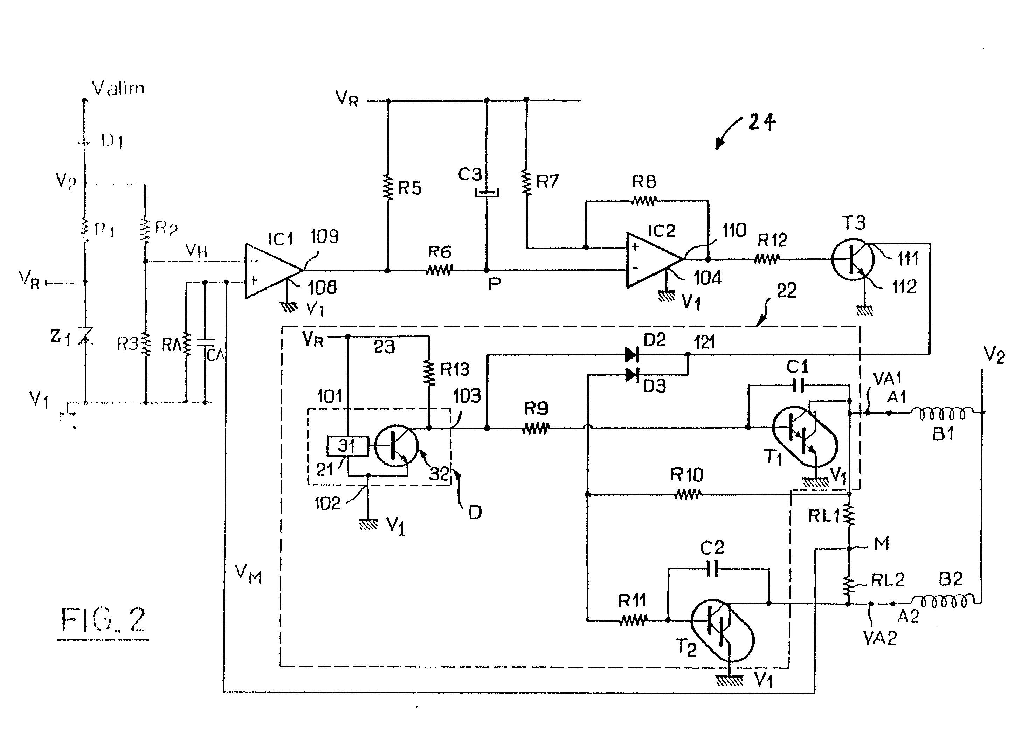

A la figure 2, on retrouve les enroulements $B_1$ et $B_2$, le détecteur D et deux transistors NPN Darlington à double étage $T_1$ et $T_2$ constituant les interrupteurs $S_1$ et $S_2$.

Les deux enroulements moteurs $B_1$ et $B_2$ ont chacun une extrémité reliée à la borne d'alimentation positive $V_2$ du moteur, séparée de la source VALIM par une diode $D_1$ protégeant l'ensemble contre les inversions de polarité.

L'autre extrémité $A_1$, $A_2$ des enroulements $B_1$, $B_2$ est reliée au collecteur de deux transistors NPN Darlington $T_1$ et $T_2$ respectivement, dont l'émetteur est relié à la masse $V_1$ qui représente la borne d'entrée négative du moteur et sera prise comme origine des potentiels ($V_1 = 0$).

Les transistors $T_1$ et $T_2$ forment avec le détecteur D apparaissant à la figure 1, l'essentiel de moyens 22 de commutation pour fermer et ouvrir successivement les circuits d'alimentation des enroulements $B_1$ et $B_2$ en fonction de la position angulaire du rotor.

Le détecteur D comprend essentiellement un générateur de Hall 31 sensible au champ magnétique et un transistor NPN 32 dont l'émetteur est relié à la borne d'entrée négative 21 du générateur et la base à l'une des sorties de celui-ci, le collecteur du transistor 32 constituant la sortie 103 du détecteur D. Celui-ci est alimenté par une ligne 23 sous une tension stabilisée VR indépendante des variations de la tension VALIM d'alimentation du moteur, fournie au point commun entre une diode Zener $Z_1$ et une résistance $R_1$ montées en série entre la borne $V_2$ et la masse $V_1$. La sortie du détecteur D est reliée à la ligne 23 par une résistance $R_{13}$ à la base du transistor $T_1$ par une résistance $R_9$, tandis que deux résistances en série $R_{10}$ et $R_{11}$ joignent le collecteur du transistor $T_1$ à la base du transistor $T_2$.

Deux condensateurs antiparasites $C_1$, $C_2$ sont montés en parallèle avec les trajets collecteur-base des transistors $T_1$ et $T_2$ respectivement.

Le moteur, selon la présente invention, comprend également un circuit 24 de détection de basse vitesse. Ce circuit utilise entre autres composants, deux comparateurs $IC_1$ et $IC_2$, qui comportent chacun une entrée inverseuse (signe — sur le schéma) une entrée non inverseuse (signe +) une alimentation 104, 108 et une sortie 109, 110.

Lorsque le potentiel de l'entrée inverseuse d'un comparateur ($IC_1$ ou $IC_2$) est supérieur à celui de l'entrée non inverseuse, la sortie est reliée à son potentiel d'alimentation (108, 104).

Dans le cas contraire, la sortie est déconnectée de l'alimentation de sorte que le potentiel de sortie est déterminé uniquement par le circuit en aval du comparateur.

L'entrée inverseuse du comparateur $IC_1$ soumise à une tension de référence $V_H$, est reliée à cet effet au point médian d'un diviseur de tension $R_2$, $R_3$, branché entre les bornes d'alimentation $V_2$ et $V_1$ ; son entrée non inverseuse est reliée au point commun M entre résistances de liaison $RL_1$, $RL_2$ montées en série entre les extrémités $A_1$, $A_2$ des enroulements $B_1$, $B_2$.

L'entrée non inverseuse du comparateur $IC_1$ est également reliée à la masse $V_1$ par l'intermédiaire d'une résistance $R_A$ et d'un condensateur $C_A$ montés en parallèle.

La sortie 109 du comparateur $IC_1$ est reliée par une résistance $R_5$ à la tension stabilisée $V_R$ et par une résistance $R_6$ à l'entrée inverseuse du second comparateur $IC_2$, dont l'alimentation, comme celle du comparateur $IC_1$, est à la tension $V_1 = 0$. L'entrée non inverseuse de ce comparateur $IC_2$ est reliée à la tension stabilisée $V_R$ par une résistance $R_7$ et à sa sortie 110 par une résistance $R_8$. Un condensateur chimique $C_3$ est monté entre la tension $V_R$ et l'entrée inverseuse du comparateur $IC_2$. La sortie 110 du comparateur $IC_2$ est reliée à la base d'un transistor NPN $T_3$ dont l'émetteur 112 relié à la masse $V_1$ et le collecteur 111 est relié au point 121 commun aux deux cathodes de deux diodes $D_2$ et $D_3$. L'anode de la diode $D_2$ est raccordée à la sortie 103 du détecteur de position D, tandis que l'anode de la diode $D_3$ est reliée au point commun entre les résistances $R_{10}$ et $R_{11}$.

Le fonctionnement du moteur ainsi constitué est le suivant :

Le transistor $T_3$ étant supposé bloqué pour des raisons exposées plus loin, lorsque le rotor 1 tourne, la sortie du détecteur D passe alternativement de $V_1 = 0$ à $V_R$ et inversement en fonction de la position du rotor 1 dont le champ magnétique agit alternativement dans un sens ou dans l'autre sur le générateur de Hall 31 sensible au champ magnétique dont la sortie binaire de faible puissance est $V_R$ ou $V_1 = 0$.

Lorsque la sortie 103 du détecteur D est au potentiel zéro $T_1$ est bloqué. Aucun courant ne parcourt donc $B_1$ et le point $A_1$ est ainsi à un potentiel supérieur à $V_1$, qui sature $T_2$ via la résistance $R_{10}$ et $R_{11}$. $T_2$ est ainsi rendu passant et $B_2$ est alimenté et parcouru par un courant $I_2$. Lorsque la sortie 103 est au potentiel $V_R$, $T_1$ est conducteur, de sorte que $A_1$ est au potentiel $V_1$, $T_2$ est bloqué et seul l'enroulement

**0 120 723**

$B_1$ est alimenté et parcouru par un courant $I_1$.

En examinant la figure 1, on suppose d'abord que lorsque le détecteur D est face au pôle nord du rotor l'enroulement $B_1$ est alimenté, faisant apparaître un pôle sud à la région 7, et que le rotor tourne dans le sens de la flèche F (sens horaire). Lorsqu'une génératrice séparant les pôles du rotor passe devant le détecteur D, s'amorce le processus par lequel s'ouvre l'un et se ferme l'autre des circuits d'alimentation des enroulements.

Le détecteur D est positionné avec une avance angulaire $\beta$ par rapport au plan O, $\pi$ de manière à tenir compte de légers retards à la commutation et notamment du délai de variation des courants dans les enroulements $B_1$, $B_2$. De cette façon, le champ magnétique créé par les enroulements se traduit toujours par un couple moteur dans le sens de la flèche F.

Pour que la rotation s'entretienne, il suffit que le transistor $T_3$ soit bloqué.

Si le transistor $T_3$ passe à l'état conducteur la sortie 103 du détecteur D et le point commun aux résistances $R_{10}$ et $R_{11}$ sont maintenus à la tension $V_1$, ce qui bloque les transistors $T_1$, $T_2$ et interrompt donc toute alimentation des enroulements $B_1$, $B_2$ quel que soit le champ magnétique subi par le générateur $B_1$.

L'état du transistor $T_3$ est commandé par le dispositif de détection de basse vitesse 24, objet de l'invention dont le fonctionnement est le suivant.

Lorsque le moteur tourne normalement, le couple moteur est entretenu, on l'a vu plus haut, parce que les extrémités $A_1$, $A_2$ des enroulements sont alternativement reliées à la masse $V_1$ ou en l'air.

Dans le second cas, l'extrémité A (soit $A_1$, soit $A_2$) de l'enroulement ($B_1$ ou $B_2$) est au potentiel $V_2$ augmenté d'une force électromotrice (f.e.m.) induite sur l'enroulement par les aimants 4, 5 en rotation.

Cette f.e.m. est toujours additionnée à $V_2$ ; par exemple si $V_1 = 0$, $V_2$ positive, cette f.e.m. sera positive.

En effet dans l'enroulement alimenté, qui engendre le couple moteur, la force contre-électromotrice induite annule $V_2$ aux pertes en ligne près. Au contraire dans l'enroulement non alimenté la force électromotrice f.e.m. s'additionne à $V_2$.

Si le moteur tourne à une vitesse basse, cette f.e.m. induite devient faible et le potentiel devient $V_2$ + Va, Va étant faible devant la f.e.m. induite à vitesse normale.

Le principe de la présente invention consiste, quelle que soit la configuration du moteur et son état à un instant donné, à détecter quand la valeur de cette f.e.m. induite sur les enroulements non alimentés descend au-dessous d'un seuil déterminé, permettant de signaler que la vitesse angulaire du rotor est inférieure à un certain seuil de vitesse.

Dans le premier exemple décrit (figure 2) les points A ($A_1$, $A_2$) sont reliés à un point commun M par des résistances de liaison $R_L$ ($R_{L1}$, $R_{L2}$) de valeur ohmique élevée, ce point M étant relié au potentiel de la masse $V_1$ par l'intermédiaire d'une résistance supplémentaire $R_A$. Par exemple si toutes les résistances de liaison $R_L$ ($R_{L1}$, $R_{L2}$) sont égales, le potentiel du point M est représentatif de la somme des potentiels aux points A, $V_M = k\Sigma V_A$, k étant un nombre constant déterminé par les valeurs relatives des résistances $R_L$ et $R_A$.

En comparant au moyen du comparateur $IC_1$ le potentiel $V_M$ avec le potentiel $V_H$ fixé à l'avance, il est possible de générer un signal à la sortie 109 du comparateur $IC_1$ qui indique si le moteur tourne à une vitesse normale (sortie en l'air) ou si le moteur tourne à une vitesse inférieure à un certain seuil (sortie connectée à $V_1$).

Ce signal peut être utilisé, par exemple, pour couper directement l'alimentation du moteur. Cependant pour éviter des coupures intempestives dues à des causes éphémères, il est prévu dans l'exemple représenté de temporiser cette coupure, ce qui permet en outre au moteur de démarrer sans qu'il faille prévoir un dispositif spécial mettant hors service la surveillance de vitesse au démarrage. A cet effet, la sortie 109 du comparateur $IC_1$ correspondant à vitesse basse est au potentiel $V_1$ ($V_1 = 0$). Le condensateur de grande capacité $C_3$, comme par exemple un condensateur chimique, étant entre $V_1$ et $V_R$ se charge à travers $R_6$.

Lorsque après un temps de charge $t_1$ la tension aux bornes du condensateur $C_3$ dépasse celle aux bornes de $R_7$, soit $[R_7/(R_7 + R_8)] V_R$, la sortie 110 du comparateur $IC_2$ est libérée et la base du transistor $T_3$ est reliée à $V_R$ par l'intermédiaire des résistances $R_7$, $R_8$ et $R_{12}$, et $T_3$ devient conducteur, bloquant les transistors $T_1$ et $T_2$ et interrompant par conséquent l'alimentation des enroulements $B_1$ et $B_2$, indépendamment de l'état du détecteur D.

Lorsque les transistors $T_1$ et $T_2$ sont bloqués simultanément, les points $A_1$ et $A_2$ sont tous deux au potentiel $V_2$ le comparateur $IC_1$ bascule (sortie 109 à $V_1 = 0$) et le condensateur $C_3$ se décharge dans les résistances $R_5$ et $R_6$. Après un temps de décharge $t_2$, le condensateur $C_3$ applique à l'entrée inverseuse du comparateur $IC_2$ un potentiel inférieur à celui de son entrée non inverseuse, maintenu voisin de $V_R$ et défini par le diviseur de tension constitué par les résistances $R_7$ d'une part, $R_8$, $R_{12}$ et la résistance base-émetteur du transistor $T_3$ d'autre part. Le comparateur $IC_2$ bascule de nouveau et bloque $T_3$, autorisant l'alimentation des enroulements. Tant que subsiste la cause de courant excessif comme par exemple le freinage du rotor, ce cycle se répète, les enroulements étant alternativement alimentés pendant une durée $t'_1$ légèrement inférieure à la durée initiale $t_1$ puisque la tension minimale du condensateur $C_3$ n'est plus nulle, et non alimentés pendant la durée $t_2$. Les résistances $R_5$ et $R_6$ qui constituent avec le condensateur $C_3$ un circuit de temporisation destiné à introduire le retard $t_1$

4

**0 120 723**

(éventuellement $t'_1$) ou $t_2$ entre le basculement du comparateur $IC_1$ et celui du comparateur $IC_2$, sont choisies de sorte que $t_2$ soit grand relativement à $t_1$ ou $t'_1$, par exemple 10 secondes contre 1 seconde environ. De cette façon, le courant moyen dans les enroulements est suffisamment faible pour éviter toute détérioration. Si la cause perturbatrice disparaît, le moteur démarre spontanément.

Il est possible de prélever à la sortie du comparateur $IC_2$ un signal binaire qui présente une valeur (zéro) lorsque les enroulements $B_1$, $B_2$ sont alimentés à tour de rôle et l'autre valeur voisine de $V_R$ lorsqu'ils ne sont pas alimentés.

Au démarrage la vitesse est nulle puis faible, la f.e.m. induite également et la tension en M est inférieure au seuil $V_H$ tant que la vitesse du rotor n'a pas dépassé le seuil de vitesse. La temporisation $t_1$ est choisie supérieure au temps que met le rotor 1 pour passer de la vitesse nulle à une vitesse supérieure au seuil de vitesse prédéterminée.

Dans le dispositif décrit une même mesure de tensions sur deux enroulements, permet d'une part de produire le signal de vitesse basse après une première temporisation $t_1$ et d'autre part de supprimer ce signal après une seconde temporisation $t_2$, de façon que le moteur puisse repartir spontanément lorsque la cause du blocage a disparu. Pour cela il est nécessaire d'effectuer la mesure sur deux enroulements au moins et qu'à chaque instant l'un d'eux au moins soit alimenté, faute de quoi si le blocage intervient alors que le ou les enroulements considérés ne sont pas alimentés, il ne serait pas possible de détecter l'interruption de l'alimentation si celle-ci se fait par le même interrupteur que la commutation normale.

Par exemple si dans le circuit décrit ci-dessus on voulait détecter le blocage du rotor en prélevant le potentiel du seul point $A_1$, on pourrait mesurer la valeur maximale de ce potentiel dans le temps. Cette valeur maximale est supérieure à $V_2$ lorsque le rotor tourne. Lorsque le rotor est freiné, le potentiel est constant et égal à zéro ou $V_2$ selon que $T_1$ est conducteur ou non, donc ne dépasse pas $V_2$, ce qui permet de détecter le blocage. En revanche dans le cas où le transistor $T_1$ est bloqué la conduction de $T_3$ n'a aucun effet sur l'enroulement $B_1$ et le signal de blocage ne peut pas être supprimé.

La coupure de l'alimentation n'est pas toujours nécessaire. L'invention peut être mise en œuvre seulement pour signaler le freinage du moteur, notamment lorsque celui-ci peut supporter sans dommage les surintensités qui en résultent.

Dans l'exemple de la figure 2, les résistances $R_{L1}$ et $R_{L2}$ étant égales, la tension $V_M$ est la même pour une vitesse donnée du rotor quel que soit l'enroulement $B_1$ ou $B_2$ alimenté. La tension $V_M$ peut donc être assimilée à une grandeur G caractéristique de la vitesse de rotation du rotor 1.

D'une façon plus générale si on considère un moteur dans lequel on mesure les tensions $V_{Ai}$ en n points $A_i$ situés respectivement entre des enroulements $B_i$ et les interrupteurs $T_i$ correspondants, un nombre constant m de ces interrupteurs étant ouverts à chaque instant, et chaque interrupteur $T_i$ étant branché entre le point $A_i$ et une borne d'alimentation à un premier potentiel $V1_i$ tandis que l'enroulement $B_i$ est branché entre le point $A_i$ et une autre borne d'alimentation à un deuxième potentiel $V2_i$, il est possible de détecter une vitesse anormalement basse de ce moteur en combinant ces mesures en une grandeur G qui est une fonction monotone de

$$\sum_{1}^{n} \frac{VA_i - V1_i}{V2_i - V1_i},$$

c'est-à-dire une fonction qui varie toujours dans un même sens lorsque cette somme augmente. En effet, lorsque le moteur est sous tension et arrêté

$$\frac{VA_i - V1_i}{V2_i - V1_i}$$

est égal à 1 pour les m enroulements non alimentés et à zéro pour les n — m enroulements alimentés, donc la somme est égale à m. Lorsque le moteur tourne la fraction est supérieure à 1 pour les m enroulements non alimentés (la f.e.m. induite s'ajoutant en valeur absolue à la tension d'alimentation) et toujours nulle pour les autres enroulements de sorte que la somme est supérieure à m et d'autant plus grande que les f.e.m. et par conséquent la vitesse du moteur sont plus élevées. La grandeur G s'écarte donc d'autant plus de sa valeur à l'arrêt que la vitesse est plus élevée et constitue ainsi une image de cette vitesse, dont la surveillance permet de détecter une vitesse basse.

Une telle grandeur G peut être fournie, lorsque les tensions d'alimentation $V2_i$-$V1_i$ des différents enroulements sont toutes de même signe, par le potentiel $V_M$ en un point M relié aux points $A_i$ par des résistances $RL_i$ dont les valeurs sont proportionnelles aux tensions $V2_i$-$V1_i$, soit $RL_i = k(V2_i-V1_i)$, le point M pouvant en outre être relié par une résistance supplémentaire RA à un point présentant un potentiel constant $V_0$. La loi des nœuds de Kirchhof donne alors :

$$\sum_{1}^{n} \frac{VM - VA_i}{RL_i} + \frac{VM - V_0}{RA} = 0$$

5

(lorsque la liaison au potentiel constant n'existe pas RA est infini et le second terme est nul).

$$VM\left(\sum_1^n \frac{1}{RL_i} + \frac{1}{RA}\right) = \sum_1^n \frac{VA_i}{RL_i} + \frac{V_0}{RA} = \frac{1}{k}\sum_1^n \frac{VA_i}{V2_i - V1_i} + \frac{V_0}{RA}$$

VM est donc une fonction linéaire, donc monotone, de

$$\sum_1^n \frac{VA_i}{V2_i - V1_i}$$

et par conséquent de

$$\sum_1^n \frac{VA_i - V1_i}{V2_i - V1_i} = \sum_1^n \frac{VA_i}{V2_i - V1_i} - \sum_1^n \frac{V1_i}{V2_i - V1_i}$$

puisque les termes

$$\frac{V1_i}{V2_i - V1_i}$$

sont constants.

Les variations de f.e.m. sur les enroulements engendrées par les variations du flux du champ magnétique capté sur l'enroulement lors de la rotation à vitesse constante du rotor, sont amorties en majeure partie par le condensateur $C_A$. La grandeur G entachée de ces variations est ainsi lissée par ce condensateur $C_A$ ce qui apporte plus de précision dans le dispositif de détection de vitesse basse.

Dans le cas où $V_1$ est l'origine des potentiels (soit $V_1 = 0$), où les résistances de liaison entre les points A des enroulements et le point commun M sont égales à $R_L$, où la résistance supplémentaire entre le point M et le potentiel $V_1$ est $R_A$, où m est le nombre d'interrupteurs S ouvert à chaque instant, n le nombre total d'enroulements, la grandeur G est la tension mesurée au point M, $V_M$, le seuil de détection de vitesse basse est avantageusement fixé à

$$V_H = (1 + a)\frac{mRA}{nRA + RL} V_2$$

a étant un nombre positif petit devant la valeur correspondant à une vitesse normale de rotation f.e.m. nominale/$V_2$.

Ce seuil $V_H$ étant pris comme potentiel de référence, le signal de vitesse basse sera déclenché ou non selon que la tension mesurée en M est inférieure ou supérieure à ce potentiel de référence.

Par ailleurs, le dispositif peut être simplifié en n'effectuant les mesures ci-dessus que sur deux enroulements seulement et non sur la totalité, un de ces enroulements seulement et non sur la totalité, un de ces enroulements étant à tout instant alimenté et l'autre non, alternativement.

**Revendications**

1. Moteur à courant continu comprenant au moins deux enroulements (B1, B2), des moyens pour relier une première extrémité de chacun de ces enroulements à une première borne de tension continue (V2), des moyens pour relier une seconde extrémité (A1, A2) de chaque enroulement (B1, B2) à une seconde borne de tension continue (V1) par l'intermédiaire d'un commutateur respectif (T1, T2), un élément (1) mobile en rotation par rapport aux enroulements (B1, B2) et présentant des pôles magnétiques disposés de façon à interagir avec les enroulements pour produire un couple moteur, des moyens (D) pour commander les commutateurs (T1, T2) de façon que sensiblement tout au long d'un tour complet de l'élément, et parmi un groupe comprenant au moins deux des enroulements précités et pouvant comprendre la totalité des enroulements du moteur, il y ait un nombre constant d'enroulements qui soient alimentés et un nombre constant d'enroulements (B1, B2) qui ne soient pas alimentés, et un dispositif de détection sensible à la vitesse du moteur, caractérisé en ce que la seconde extrémité (A1, A2) de chaque enroulement du groupe précité est en outre reliée à un point commun (M) par l'intermédiaire d'une résistance respective (RL1, RL2), et en ce que le point commun (M) est relié à l'entrée de moyens de comparaison (IC1) pour comparer le potentiel (VM) présent au point commun (M) avec un seuil de potentiel prédéterminé correspondant à un seuil de vitesse prédéterminé, de façon à détecter si la vitesse du moteur est inférieure audit seuil de vitesse.

**0 120 723**

2. Moteur selon la revendication 1, caractérisé en ce que chacune des première et seconde bornes de tension (V2, V1) est commune pour tous les enroulements (B1, B2), et les résistances (RL1, RL2) reliant chaque enroulement au point commun (M) ont même valeur ohmique.

3. Moteur selon l'une des revendications 1 ou 2, caractérisé en ce que le dispositif de détection comprend des moyens (T3, D2, D3) pour interrompre le courant vers les enroulements (B1, B2) si la vitesse du moteur est inférieure au seuil de vitesse précité.

4. Moteur selon la revendication 3, caractérisé en ce que les moyens de comparaison comprennent un comparateur (IC1) ayant une entrée reliée au point commun et à une troisième borne de tension (V1) par l'intermédiaire d'une résistance (RA).

5. Moteur selon la revendication 4, caractérisé en ce que ladite entrée du comparateur est en outre reliée à la troisième borne de tension par l'intermédiaire d'un condensateur (CA).

6. Moteur selon l'une des revendications 3 à 5, caractérisé en ce qu'il comprend des moyens (C3, R6, IC2) pour retarder l'interruption du courant vers les enroulements par les moyens pour interrompre le courant vers les enroulements (T3, D2, D3) après que les moyens de comparaison (IC1) ont détecté que la vitesse du moteur est inférieure au seuil.

7. Moteur selon la revendication 6, caractérisé en ce que les moyens pour interrompre le courant vers les enroulements comprennent des moyens (T3, D2, D3) pour ouvrir les commutateurs (T1, T2) associés à tous les enroulements (B1, B2).

8. Moteur selon la revendication 7, caractérisé en ce que le seuil de potentiel est inférieur au potentiel du point commun (M) lorsque les commutateurs (T1, T2) sont tous ouverts, et en ce que des moyens (IC2, C3, R6, R5) sont prévus pour, après une interruption commandée par les moyens de comparaison (IC1), rétablir le courant dans les enroulements un certain délai après que le potentiel (VM) au point commun (M) a franchi dans le sens croissant le seuil de potentiel et s'est maintenu au-dessus de ce seuil.

**Claims**

1. A d.c. motor comprising : at least two windings (B1, B2) ; means for connecting a first end of each such winding to a first d.c. voltage terminal (V2) ; means for connecting a second end (A1, A2) of each winding (B1, B2) to a second d.c. voltage terminal (V1) by way of a respective switch (T1, T2) ; an element (1) rotatable relatively to the windings (B1, B2) and having magnetic poles arranged to interact with the windings to produce a driving torque ; means (D) for so controlling the switches (T1, T2) that substantially through one complete revolution of the element and from a group comprising at least two of the windings and possibly all the windings of the motor there is a constant number of windings which are energized and a constant number of windings (B1, B2) which are not energized ; and a motor speed detector, characterized in that the second end (A1, A2) of each winding (B1, B2) of the group is also connected to a common point (M) by way of a respective resistance (RL1, RL2), and the common point (M) is connected to the input of a comparison means (IC1) for comparing the potential (VM) at the common point (M) with a predetermined potential threshold corresponding to a predetermined speed threshold so as to detect whether motor speed is below the speed threshold.

2. A motor according to claim 1, characterised in that each of the first and second voltage terminals (V2, V1) is common to all the windings (B1, B2) and the resistances (RL1, RL2) connecting each winding to the common point (M) have the same ohmic value.

3. A motor according to claim 1 and/or 2, characterised in that the detector comprises means (T3, D2, D3) to interrupt the current to the windings (B1, B2) if the motor speed is below the said speed threshold.

4. A motor according to claim 3, characterised in that the comparison means comprise a comparator (IC1) having one input connected to the common point and to a third voltage terminal (V1) by way of a resistance (RA).

5. A motor according to claim 4, characterised in that said comparator input is also connected to the third voltage terminal by way of a capacitor (CA).

6. A motor according to any of claims 3-5, characterised in that it comprises means (C3, R6, IC2) for delaying interruption of the current to the windings by the interrupting means (T3, D2, D3) after the comparison means (IC1) have detected that motor speed is below the threshold.

7. A motor according to claim 6, characterised in that the current-interrupting means comprise means (T3, D2, D3) for opening the switches (T1, T2) associated with all the windings (B1, B2).

8. A motor according to claim 7, characterised in that the potential threshold is below the potential at the common point (M) when all the switches (T1, T2) are open, and means (IC2, C3, R6, R5) are provided which are operative after an interruption initiated by the comparison means (IC1) to restore the current in the windings at a time after the potential (VM) at the common point (M) has reached the potential threshold in the growth direction and has remained above such threshold.

**Patentansprüche**

7

1. Gleichstrommotor mit wenigstens zwei Wicklungen (B1, B2), Mitteln zum Verbinden eines ersten Endes jeder dieser Wicklungen mit einem ersten Gleichspannungsanschluß (V2), Mitteln zum Verbinden eines zweiten Endes (A1, A2) jeder Wicklung (B1, B2) mit einem zweiten Gleichspannungsanschluß (V1) über einen zugehörigen Schalter (T1, T2), einem bezüglich den Wicklungen (B1, B2) drehbeweglichen Element (1), das Magnetpole aufweist, die derart angeordnet sind, daß sie in Wechselwirkung mit den Wicklungen treten, um ein Antriebsmoment zu erzeugen, Mitteln (D) zum Steuern der Schalter (T1, T2) in solcher Weise, daß über im wesentlichen eine gesamte vollständige Umdrehung des Elementes in einer Gruppe, die wenigstens zwei der vorgenannten Wicklungen enthält und die Gesamtheit von Wicklungen des Motors umfassen kann, eine konstante Anzahl von Wicklungen gespeist wird und eine konstante Anzahl von Wicklungen (B1, B2) nicht gespeist wird, und mit einer Detektionsvorrichtung, welche auf die Motorgeschwindigkeit anspricht, dadurch gekennzeichnet, daß das zweite Ende (A1, A2) jeder Wicklung der vorgenannten Gruppe ferner mit einem gemeinsamen Punkt (M) über einen zugehörigen Widerstand (RL1, RL2) verbunden ist und daß der gemeinsame Punkt (M) mit dem Eingang von Vergleichermitteln (IC1) verbunden ist, um das am gemeinsamen Punkt (M) vorhandene Potential (VM) mit einem vorbestimmten Potentialschwellwert zu vergleichen, welcher einem vorbestimmten Geschwindigkeitsschwellwert entspricht, so daß festgestellt wird, ob die Motorgeschwindigkeit kleiner als der genannte Geschwindigkeitsschwellwert ist.

2. Motor nach Anspruch 1, dadurch gekennzeichnet, daß sowohl der erste als auch der zweite Spannungsanschluß (V2, V1) allen Wicklungen (B1, B2) gemeinsam ist und die Widerstände (RL1, RL2), die jede Wicklung mit dem gemeinsamen Punkt (M) verbinden, denselben ohmschen Wert aufweisen.

3. Motor nach Anspruch 1 oder 2, dadurch gekennzeichnet, daß die Detektionsvorrichtung Mittel (T3, D2, D3) umfaßt, um den Strom zu den Wicklungen (B1, B2) zu unterbrechen, wenn die Motorgeschwindigkeit geringer als der vorbestimmte Geschwindigkeitsschwellwert ist.

4. Motor nach Anspruch 3, dadurch gekennzeichnet, daß die Vergleichermittel einen Vergleicher (IC1) umfassen, dessen einer Eingang mit dem gemeinsamen Punkt und über einen Widerstand (RA) mit einem dritten Spannungsanschluß (V1) verbunden ist.

5. Motor nach Anspruch 4, dadurch gekennzeichnet, daß der genannte Eingang des Vergleichers ferner mit dem dritten Spannungsanschluß über einen Kondensator (CA) verbunden ist.

6. Motor nach einem der Ansprüche 3 bis 5, dadurch gekennzeichnet, daß er Mittel (C3, R6, IC2) zum Verzögern der Stromunterbrechung an den Wicklungen durch die Mittel, durch welche der Strom zu den Wicklungen (T3, D2, D3) unterbrochen wird, nachdem die Vergleichermittel (IC1) festgestellt haben, daß die Motorgeschwindigkeit kleiner als der Schwellwert ist, umfasst.

7. Motor nach Anspruch 6, dadurch gekennzeichnet, daß die Mittel zum Unterbrechen des Stromes zu den Wicklungen Mittel (T3, D2, D3) umfassen, um die allen Wicklungen (B1, B2) zugeordneten Schalter (T1, T2) zu öffnen.

8. Motor nach Anspruch 7, dadurch gekennzeichnet, daß der Potentialschwellwert kleiner als das Potential des gemeinsamen Punktes (M) ist, wenn alle Schalter (T1, T2) offen sind, und daß Mittel (IC2, C3, R6, R5) vorgesehen sind, um nach einer durch die Vergleichermittel (IC1) gesteuerten Unterbrechung den Strom in den Wicklungen mit einer bestimmten Verzögerung wiederherzustellen, nachdem das Potential (VM) am gemeinsamen Punkt (M) den Potentialschwellwert in zunehmendem Sinne überschritten hat und über diesem Schwellwert verblieben ist.

$$FIG.1$$

FIG. 2